(19) Europäisches Patentamt / European Patent Office / Office européen des brevets

(11) **EP 3 915 779 A1**

(12) # EUROPEAN PATENT APPLICATION
published in accordance with Art. 153(4) EPC

(43) Date of publication:
**01.12.2021 Bulletin 2021/48**

(21) Application number: **20745002.4**

(22) Date of filing: **22.01.2020**

(51) Int Cl.:
*B32B 15/08* (2006.01)    *B29C 43/48* (2006.01)
*H05K 3/00* (2006.01)

(86) International application number:
**PCT/JP2020/002058**

(87) International publication number:
**WO 2020/153391 (30.07.2020 Gazette 2020/31)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **25.01.2019 JP 2019011241**

(71) Applicant: **Denka Company Limited**
**Tokyo 103-8338 (JP)**

(72) Inventors:
• **INODA, Ikuka**
**Chuo-ku**
**Tokyo 103-8338 (JP)**
• **MASUDA, Yusuke**
**Chuo-ku**
**Tokyo 103-8338 (JP)**
• **UCHIYAMA, Shun**
**Chuo-ku**
**Tokyo 103-8338 (JP)**
• **EBISUZAKI, Takako**
**Chuo-ku**
**Tokyo 103-8338 (JP)**

(74) Representative: **Murgitroyd & Company**
**Murgitroyd House**
**165-169 Scotland Street**
**Glasgow G5 8PL (GB)**

(54) **DOUBLE-SIDED METAL-CLAD LAMINATE AND PRODUCTION METHOD THEREFOR, INSULATING FILM, AND ELECTRONIC CIRCUIT BASE BOARD**

(57)    A method of producing a double-sided metal-clad laminate comprises a supplying step of supplying an insulating film interposed between two metal foils continuously to between a pair of endless belts, a heat and pressure applying step of forming a laminate of the insulating film and the metal foils by heating and applying a pressure to the insulating film and the metal foils under predetermined condition while the insulating film is interposed by the two metal foils in between the endless belts, and a cooling step of cooling the laminate, wherein the insulating film has a thickness of 10 to 500 $\mu$m, a degree of planar orientation of 30% or more, an average coefficient of linear expansion in an MD direction of -40 to 0 ppm/K and an average coefficient of linear expansion in a TD direction of 0 to 120 ppm/K. A double-sided metal-clad produced by the method, an insulating film used for the method and an electric circuit board using the double-sided metal-clad are also provided.

FIG. 1

**Description**

TECHNICAL FIELD

The present invention relates to a double-sided metal-clad laminate and a production method therefor, an insulating film used in the production method, and an electronic circuit base board including the double-sided metal-clad laminate.

BACKGROUND ART

A thermoplastic liquid crystal polymer (LCP) is excellent in heat resistance, mechanical strength, electrical properties, and the like and has therefore been widely used as an insulating film for an electronic circuit base board in the field of electrics and electronics as well as the field of in-vehicle components.

A thermoplastic liquid crystal polymer film has a structure having rigid linear molecular chains regularly arranged, and is therefore prone to develop anisotropy. For this reason, a film obtained by extrusion molding of a thermoplastic liquid crystal polymer while using a T-die or the like is generally prone to develop a high degree of molecular orientation in a direction of extrusion in a plane. As a consequence, external appearance of the film may be deformed due to the difference in the coefficients of linear expansion between the direction of extrusion and a perpendicular direction thereto at the time when the film is heated.

For this reason, in a case of producing a double-sided metal-clad laminate by using the thermoplastic liquid crystal polymer film as an insulating film therein, a method is adopted in which a treatment to reduce the anisotropy in the thermoplastic liquid crystal polymer film is performed before the thermoplastic liquid crystal polymer film is laminated and integrated with metal foils.

A number of production techniques have been disclosed as the method of producing the double-sided metal-clad laminate by using the thermoplastic liquid crystal polymer film. For example, Patent Literature 1 discloses a method of producing a laminate board for a flexible printed wiring board by carrying out thermocompression forming while continuously supplying metal foils and an insulating film that is made of a liquid crystal polymer to between a pair of endless belts. This method specifies a surface roughness of the metal foils and a heating temperature at the time of the thermocompression forming. Meanwhile, Patent Literature 2 discloses a method of producing a flexible laminate board by carrying out thermocompression bonding while continuously supplying metal foils and an insulating film that is made of a liquid crystal polymer to between a pair of endless belts. This method specifies a maximum temperature of the flexible laminate board and an exit temperature at the time when the flexible laminate board is discharged from the endless belts.

CITATION LIST

Patent Literature

Patent Literature 1: Japanese Patent No. 5411656
Patent Literature 2: Japanese Patent Application Publication No. 2016-129949

SUMMARY OF INVENTION

Technical Problem

Nonetheless, although the heating temperature at the time of the thermocompression forming is set equal to or above the melting point of the liquid crystal polymer according to the producing method disclosed in Patent Literature 1, anisotropy is apt to remain in the case of using a thermoplastic liquid crystal polymer film having a strong anisotropy. If the anisotropy remains in the film, the laminate plate may be warped or deformed or may develop burrs or cracks when it is subjected to a drilling process. Meanwhile, the producing method disclosed in Patent Literature 2 is designed to set the heating temperature below the melting point of the liquid crystal polymer at the time of the thermocompression bonding. Accordingly, anisotropy is apt to remain in the case of using a thermoplastic liquid crystal polymer film having a strong anisotropy as with the method according to Patent Literature 1.

The present invention has been made in view of the aforementioned circumstances. Specifically, an object of the present invention is to provide a double-sided metal-clad laminate, which enables the use of an insulating film made of a thermoplastic liquid crystal polymer having a strong anisotropy, and in which a thermoplastic liquid crystal polymer layer of the double-sided metal-clad laminate has a small degree of planar orientation and also has a low anisotropy of dimensional change when being heated, and to provide a production method therefor. Another object of the present invention is to provide an insulating film suitably used in the production method, and an electronic circuit base board including the double-sided metal-clad laminate.

Solution to Problem

The inventors of the present invention have found out that anisotropy of an insulating film is relatively easily improved, surprisingly, by conducting heat and pressure application at a selected specific temperature and pressure for a selected specific time in a state where the insulating film made of a thermoplastic liquid crystal polymer is sandwiched with two metal foils between a pair of endless belts. Moreover, the inventors have found out that a double-sided metal-clad laminate with reduced anisotropy may be obtained by using an insulating film having a strong anisotropy without conducting a treatment in advance for reducing the anisotropy intrinsic to the thermoplastic liquid crystal polymer, which has formerly been carried out. The present invention has successfully been achieved based on the above-mentioned findings. Specifically, the present invention provides the following configurations.

(1) A method of producing a double-sided metal-clad laminate of the present invention is a method for producing a double-sided metal-clad laminate including a structure in which an insulating film containing a thermoplastic liquid crystal polymer is interposed between two metal foils, which includes a supplying step of supplying the insulating film and the two metal foils continuously to between a pair of endless belts, a heat and pressure applying step of heating and applying a pressure to the insulating film and the two metal foils while the insulating film is interposed between the two metal foils in between the endless belts and of forming the insulating film and the metal foils into a laminate, and a cooling step of cooling the laminate. Here, the insulating film has a thickness of 10 to 500 $\mu$m, a degree of planar orientation of 30% or more, an average coefficient of linear expansion in an MD direction of -40 to 0 ppm/K, and an average coefficient of linear expansion in a TD direction of 0 to 120 ppm/K. When a melting point of the thermoplastic liquid crystal polymer is defined as Tm (°C), a heating temperature T (°C) in the heat and pressure applying step complies with an inequality: (Tm + 20) < T ≤ (Tm + 70). A pressure in the heat and pressure applying step is 0.5 to 10 MPa. Heat and pressure application time in the heat and pressure applying step is 30 to 360 seconds.

(2) In the method of producing a double-sided metal-clad laminate of the present invention, a thermoplastic liquid crystal polymer layer after removing the metal foils from the obtained double-sided metal-clad laminate may be configured to have a degree of planar orientation of below 30%, an average coefficient of linear expansion in the MD direction in a range from 0 to 40 ppm/K, and an average coefficient of linear expansion in the TD direction in a range from 0 to 40 ppm/K.

(3) In the production method for a double-sided metal-clad laminate of the present invention, the metal foils are preferably copper foils.

(4) An insulating film of the present invention is an insulating film to be used in a method of producing a double-sided metal-clad laminate including a supplying step of supplying an insulating film and two metal foils continuously to between a pair of endless belts, a heat and pressure applying step of heating and applying a pressure to the insulating film and the metal foils while the insulating film is interposed between the two metal foils in between the endless belts and of forming the insulating film and the metal foils into a laminate, and a cooling step of cooling the laminate. Here, the insulating film includes a thermoplastic liquid crystal polymer, and has a thickness of 10 to 500 $\mu$m, a degree of planar orientation of 30% or more, an average coefficient of linear expansion in an MD direction of -40 to 0 ppm/K, and an average coefficient of linear expansion in a TD direction of 0 to 120 ppm/K.

(5) A double-sided metal-clad laminate of the present invention is a double-sided metal-clad laminate having a configuration in which an insulating film including a thermoplastic liquid crystal polymer is interposed between two metal foils. Here, the double-sided metal-clad laminate is produced in accordance with the method of producing a double-sided metal-clad laminate according to the section (1) or the section (2). The thermoplastic liquid crystal polymer layer after removing the metal foils has a degree of planar orientation below 30%, an average coefficient of linear expansion in the MD direction of 0 to 40 ppm/K, and an average coefficient of linear expansion in the TD direction of 0 to 40 ppm/K.

(6) In the double-sided metal-clad laminate of the present invention, the metal foils are preferably copper foils.

(7) An electronic circuit base board of the present invention includes the double-sided metal-clad laminate according to the section (5) or the section (6).

Advantageous Effects of Invention

The method of producing a double-sided metal-clad laminate according to the present invention may provide a double-sided metal-clad laminate, which enables to use an insulating film made of a thermoplastic liquid crystal polymer having a strong anisotropy, and in which a thermoplastic liquid crystal polymer layer of the double-sided metal-clad laminate has a small degree of planar orientation and also has a low anisotropy of dimensional change when being heated.

BRIEF DESCRIPTION OF DRAWINGS

FIG.1 is a schematic cross-sectional view of a production apparatus for a double-sided metal-clad laminate of an embodiment of the present invention.
FIG. 2A is a two-dimensional diffraction image of an X-ray diffraction and FIG. 2B is an intensity curve.

DESCRIPTION OF EMBODIMENTS

An embodiment of the present invention will be described below in detail. It is to be noted, however, that the technical scope of the present invention is not limited to the embodiment described below as a specific example.

(Thermoplastic liquid crystal polymer)

A thermoplastic liquid crystal polymer represents a thermoplastic polymer having a property of being liquid crystal or showing birefringence when the polymer is melted. As the thermoplastic liquid crystal polymer, a lyotropic liquid crystal polymer and a thermotropic liquid crystal polymer exist. The lyotropic liquid crystal polymer is liquid crystal in a state of liquid solution and the thermotropic liquid crystal polymer is liquid crystal when it is melted. Such thermoplastic liquid crystal polymers are categorized into type I, type II, and type III depending on heat distortion temperatures and any of these types are acceptable for this use.
Examples of the thermoplastic liquid crystal polymer include thermoplastic aromatic liquid crystal polyester, thermoplastic aromatic liquid crystal polyesteramide obtained by introducing an amide linkage to thermoplastic aromatic liquid crystal polyester, and the like. The thermoplastic liquid crystal polymer may also be a polymer obtained by further introducing any of an imide linkage, a carbonate linkage, a carbodiimide linkage, a linkage derived from isocyanate such as an isocyanurate linkage, and the like to any of the aromatic polyester and the aromatic polyesteramide.
The melting point of the thermoplastic liquid crystal polymer is preferably 220°C to 400°C, or more preferably 260°C to 380°C in accordance with the DSC method. In the case where the melting point of the thermoplastic liquid crystal polymer is the above-mentioned, a film being excellent in extrusion formability and heat resistance is obtained.
Molecules of the thermoplastic liquid crystal polymer have a rigid rod-like structure and the molecules are solidified in a state of being aligned with a direction that a forming process is proceed. Accordingly, the thermoplastic liquid crystal polymer has properties of being excellent in dimensional stability of a formed product but being prone to exhibit anisotropy.

(Insulating film)

An insulating film is a film produced by forming the thermoplastic liquid crystal polymer into a shape. A forming method for producing the insulating film from the thermoplastic liquid crystal polymer is not limited to a particular method, and examples of which include publicly known forming methods such as an extrusion forming method like an inflation method or a T-die method, a casting method, and a calendering method. Among them, the T-die method is most versatile. However, in the case of forming the film in accordance with the T-die method, a shear occurs in MD direction during passing through a T-die, whereby the thermoplastic liquid crystal polymer molecules are prone to be oriented and to exhibit anisotropy in the MD direction. Here, the MD direction is a direction that a forming process is proceed(Machine Direction) in a film plane while TD direction is a direction perpendicular to the MD direction in the film plane.
A thickness of the insulating film is 10 to 500 $\mu$m, or preferably 15 to 400 $\mu$m. In the case where the thickness of the insulating film is in the above-mentioned range, the anisotropy is reduced by fluidization of the polymer molecules when the insulating film is heated and subjected to pressure application between the endless belts in the state of being sandwiched with the two metal foils.
As mentioned above, when the film is formed from the thermoplastic liquid crystal polymer in accordance with the T-die method, the shear occurs in the MD direction, and orientation occurs in the film, whereby the film may exhibit the anisotropy in the MD direction. The film formed in accordance with the T-die method often has the degree of a planar orientation of 30 % or more, an average coefficient of linear expansion in the MD direction of -40 to 0 ppm/K, and an average coefficient of linear expansion in the TD direction of 0 to 120 ppm/K. As described later, a method of producing a double-sided metal-clad laminate according to this embodiment uses the insulating film having a strong anisotropy with the degree of planar orientation of 30% or more, the average coefficient of linear expansion in the MD direction of -40 to 0 ppm/K, and the average coefficient of linear expansion in the TD direction of 0 to 120 ppm/K, as the insulating film.

The degree of planar orientation is obtained as described below. First, a two-dimensional diffraction image is obtained by irradiating a surface of a film with X-rays from a direction perpendicular to the film surface using a wide-angle X-ray diffractometer. Next, an intensity curve is obtained by plotting an intensity in a circumferential direction of the obtained two-dimensional diffraction image. In the obtained intensity curve, a value of integral of a base portion is defined as B and a value of integral of another portion obtained by subtracting the base portion from a measured peak portion is defined as A, the degree of planar orientation is calculated by the following formula:

$$\text{Degree of planar orientation (\%)} = \{A/(A + B)\} \times 100.$$

The average coefficient of linear expansion is measured in accordance with the TMA method in compliance with JIS K7197.

[Production apparatus for double-sided metal-clad laminate]

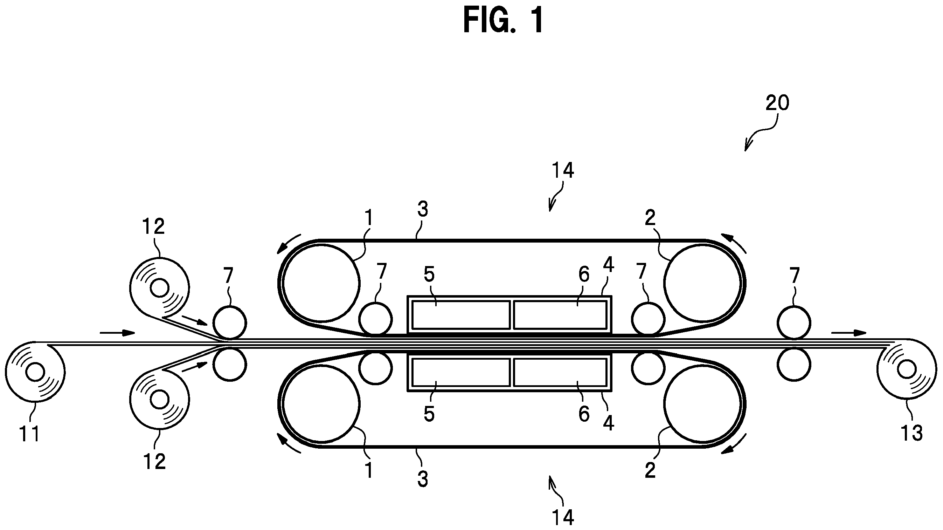

FIG. 1 is a schematic cross-sectional view of a production apparatus 20 for a double-sided metal-clad laminate of this embodiment. The production apparatus 20 for a double-sided metal-clad laminate is a production apparatus that adopts a hydraulic double belt press method, which is capable of forming a laminate by continuously heating and applying a pressure to the insulating film in a state of interposing between the two metal foils, and is therefore excellent in productivity of the double-sided metal-clad laminate.

The production apparatus 20 has a roll 11 of the insulating film and rolls 12 of the two metal foils to be laminated on both surfaces of the insulating film. The insulating film drawn out from the roll 11 is supplied to between two conveyor devices 14 in a state of being sandwiched by the two metal foils drawn out from the rolls 12.

The production apparatus 20 includes the two conveyor devices 14 that are vertically arranged. Each conveyor device 14 drives an endless belt 3 by using two endless-belt rolls 1 and 2. The conveyor device 14 has a pressure application block 4 having a built-in heater block 5 and a built-in cooler block 6 inside of the conveyor device 14. The two conveyor devices 14 heat the insulating film and the metal foils supplied in between while continuously applying a predetermined pressure thereto, and then cool the insulating film and the metal foils thereafter. The material of each endless belt 3 is not limited to a particular material and a metal, a resin, a rubber, or the like is applicable. Nevertheless, a metal is preferred in light of its heat resistance and low thermal expansion.

The pressure application block 4 has a capability of applying a predetermined pressure to the insulating film and the metal foils. The inside of the pressure application block 4 is filled with an oil. A pressure is applied to the oil inside the pressure application block 4. Applying pressure by using a hydraulic pressure brings a uniform pressure to the film surface, and appearance defects are therefore less likely to occur. The heater block 5 has a function to heat the insulating film and the metal foils to a predetermined temperature equal to or higher than the melting point of the thermoplastic liquid crystal polymer. The cooler block 6 has a function to cool the insulating film and the metal foils to a predetermined temperature equal to or lower than the solidification temperature of the thermoplastic liquid crystal polymer at a predetermined cooling rate.

The production apparatus 20 includes multiple guide rolls 7 for conveying the insulating film and the metal foils. Moreover, the production apparatus 20 coil a laminate formed from the insulating film and the metal foils that are integrated together with the two conveyor devices 14 as a roll 13.

As for each of the metal foils, a metal foil made of any of copper, a copper alloy, aluminum, an aluminum alloy, iron, an iron alloy, and the like may be used. A copper foil is desirable when the laminate is used for applications such as an electronic circuit base board.

A thickness of each metal foil is preferably 5 to 100 $\mu$m, or more preferably 7 to 50 $\mu$m. If the thickness of the metal foil exceeds 100 $\mu$m, heating and melting of the thermoplastic liquid crystal polymer by using the production apparatus 20 may be insufficient because of heat transfer. Meanwhile, the metal foil is preferably subjected to a surface treatment in order to improve adhesion to the insulating film. Examples of the surface treatment method include a surface roughening treatment, coating of a coupling agent and the like, acid and alkaline treatments, an oxidation treatment, and the like. For these surface treatment methods, publicly known methods may be adopted as appropriate.

[Production method for double-sided metal-clad laminate]

A method of producing a double-sided metal-clad laminate of this embodiment includes (1) a supplying step of supplying an insulating film and two metal foils continuously to between a pair of endless belts, (2) a heat and pressure applying step of heating and applying a pressure to the insulating film and the metal foils while the insulating film is interposed between the two metal foils in between the endless belts and of forming the insulating film and the metal foils into a laminate, (3) a cooling step of cooling the laminate, and (4) a coiling step of coiling the laminate. FIG. 1 illustrates these four steps. Although the steps of method of producing a double-sided metal-clad laminate may be carried out in accordance with a batch method, it is preferable to carry out these steps in a continuous method from the viewpoint of productivity. Now, each of the steps will be described below.

(Supplying step)

The supplying step is a step of supplying the insulating film and the two metal foils continuously to between the pair of endless belts 3 provided to the two conveyor devices 14 of the production apparatus 20. The insulating film is supplied from the roll 11 while the two metal foils to be laminated on the two surfaces of the insulating film are supplied from the rolls 12.

(Heat and pressure applying step)

The heat and pressure applying step is a step of heating and applying a pressure to the insulating film interposed between the two metal foils in between the endless belts 3 and forming the insulating film and the metal foils into the laminate.

The inventors of the present invention have conducted studies for a method of reducing the anisotropy by using the insulating film having a strong anisotropy. Using the production apparatus 20, various studies have been carried out regarding the temperature, pressure, and time when heating and applying the pressure to the two metal foils and the insulating film between the endless belts 3. As a consequence, the inventors have found out that (1) the thermoplastic liquid crystal polymer is melted when the thermoplastic liquid crystal polymer is heated to a specific temperature which is equal to or higher than the melting point of the thermoplastic liquid crystal polymer, whereby entanglement of the polymer molecules is loosened in the melted state, which leads to rapid reduction of its melt viscosity and to a significant increase in fluidity of the melted polymer, (2) the orientation of the polymer molecules generated at the time of forming is lost by maintaining a highly fluidized state under a specific pressure for specified time, whereby the anisotropy is significantly reduced, and (3) the degree of planar orientation in the thermoplastic liquid crystal polymer layer sandwiched by the metal foils is reduced by cooling and solidifying the state of losing the orientation of the polymer molecules of the insulating film, and anisotropy of a dimensional change is also reduced when being heated.

When the melting point of the thermoplastic liquid crystal polymer is defined as Tm (°C), a heating temperature T (°C) in the heat and pressure applying step needs to comply with an inequality: $(Tm + 20) < T \le (Tm + 70)$. The heating temperature T (°C) in the heat and pressure applying step more preferably complies with an inequality: $(Tm + 20) < T \le (Tm + 60)$. When the heating temperature in the heat and pressure applying step complies with the aforementioned formula, the melt viscosity of the thermoplastic liquid crystal polymer is reduced significantly, thus to fluidize the polymer molecules and to loosen the entanglement among the molecules, thereby significantly reducing the anisotropy. If the heating temperature T (°C) exceeds $(Tm + 70)$, the thermoplastic liquid crystal polymer may be deteriorated or the fluidized melted polymer may come out of the metal foils and contaminate the apparatus.

The pressure in the heat and pressure applying step is 0.5 to 10 MPa, or preferably 0.8 to 8 MPa. When the pressure in the heat and pressure applying step is 0.5 MPa or more, the insulating film sufficiently adheres to the metal foils so that the heat is easily transferred to the insulating film. Meanwhile, when the pressure in the heat and pressure applying step is 10 MPa or below, the thickness of the insulating film is not significantly reduced. Accordingly, there is a low risk of fluidization of the melted polymer that may cause the anisotropy.

Heating and pressure application time in the heatin and pressure applying step is 30 to 360 seconds, or preferably 60 to 300 seconds. When the heating and pressure application time is in the above-mentioned range, the time for melting the thermoplastic liquid crystal polymer and reducing the anisotropy is surely obtained.

According to the production method of this embodiment including the above-described heat and pressure applying step, the thermoplastic liquid crystal polymer layer of the double-sided metal-clad laminate comes to be a layer with a low anisotropy even in the case of using the insulating film having a strong anisotropy with the degree of planar orientation of 30% or more, the average coefficient of linear expansion in the MD direction of -40 to 0 ppm/K, and the average coefficient of linear expansion in the TD direction of 0 to 120 ppm/K. The thermoplastic liquid crystal polymer layer with a low anisotropy means a polymer layer having the degree of planar orientation of below 30%, the average coefficient of linear expansion in the MD direction of 0 to 40 ppm/K, and the average coefficient of linear expansion in the TD direction of 0 to 40 ppm/K.

Here, an insulating film having any of the numerical values of the degree of planar orientation, the average coefficient of linear expansion in the MD direction, and the average coefficient of linear expansion in the TD direction, which is smaller than the corresponding numerical value of the insulating film having the strong anisotropy as above is used as the insulating film in the method of producing a double-sided metal-clad laminate of this embodiment. In the meantime, the degree of planar orientation of the insulating film is preferably 80% or below.

Reasons why the anisotropy of the thermoplastic liquid crystal polymer layer is significantly improved by the production method of this embodiment as described above may be thought as follows. Specifically, since the insulating film is heated in a bound state of being interposed between the two metal foils, the melted polymer is kept from being fluidized and significantly losing its form even if the melt viscosity of the melted polymer is significantly reduced. Moreover, it is presumed that the orientation of the polymer molecules is changed into a random state by free motions of the polymer molecules inside the film at the micro level in the aforementioned state.

(Cooling step)

The cooling step is a step of cooling the laminate obtained in the heat and pressure applying step to a temperature equal to or below the solidification temperature of the thermoplastic liquid crystal polymer. The insulating film reduced in anisotropy by the heating and pressure application in the heat and pressure applying step is cooled and solidified into the thermoplastic liquid crystal polymer layer having the relaxed and reduced anisotropy. In the cooling step, it is preferable to cool down evenly so as not to leave forming distortion.

(Coiling step)

The laminate that is integrated after undergoing the heat and pressure applying step and the cooling step by using the production apparatus 20 is coiled into the coiling roll 13 as the double-sided metal-clad laminate. Alternatively, the double-sided metal-clad laminate may be cut into rectangular pieces having a predetermined length and stacked up instead of carrying out the coiling step. A line speed of the production apparatus 20 is adjusted to a speed that obtains the heating and pressuring time of 30 to 360 seconds in the heat and pressure applying step.

(Double-sided metal-clad laminate)

The double-sided metal-clad laminate of this embodiment is produced in accordance with the method of producing a double-sided metal-clad laminate by using the above-described production apparatus 20 for a double-sided metal-clad laminate. According to the method of producing a double-sided metal-clad laminate of this embodiment, the anisotropy of the insulating film used therein is significantly improved. As a consequence, the thermoplastic liquid crystal polymer layer of the double-sided metal-clad laminate has a small degree of planar orientation and a low anisotropy of dimensional change when being heated. Specifically, regarding the obtained double-sided metal-clad laminate, the thermoplastic liquid crystal polymer layer after removing the metal foils has the degree of planar orientation of below 30%, the average coefficient of linear expansion in the MD direction of 0 to 40 ppm/K, and the average coefficient of linear expansion in the TD direction of 0 to 40 ppm/K. Here, the degree of planar orientation of the thermoplastic liquid crystal polymer layer is preferably 20% or below.

Since the anisotropy of the thermoplastic liquid crystal polymer is reduced, the double-sided metal-clad laminate is less likely to be warped or deformed, and thus less likely to develop burrs or cracks when it is subjected to a drilling process.

When focused on specifications of the thermoplastic liquid crystal polymer layer after removing the metal foils, the double-sided metal-clad laminate of this embodiment may also be produced by using a production method that is different from the method of producing a double-sided metal-clad laminate of this embodiment. Specifically, the double-sided metal-clad laminate may also be produced in accordance with a method of performing a conventional treatment for reducing anisotropy intrinsic to an insulating film in advance and then performing the heating and pressuring the insulating film sandwiched with the two metal foils so as to form the laminate. However, it is difficult at this point to directly identify a difference between the double-sided metal-clad laminate of this embodiment and the double-sided metal-clad laminate produced in accordance with the conventional method from the structures or properties thereof. Accordingly, the double-sided metal-clad laminate of this embodiment will be specified by the production method therefor in order to clarify that the double-sided metal-clad laminate of this embodiment is different from the double-sided metal-clad laminate according to other production methods.

The treatment for reducing the anisotropy intrinsic to the thermoplastic liquid crystal polymer film has heretofore been carried out in advance, whereas the method of producing a double-sided metal-clad laminate of this embodiment may eliminate the aforementioned process. In other words, the method of producing a double-sided metal-clad laminate of this embodiment is a production method that is excellent in productivity thanks to more simplified production steps as compared to the related art.

Applications of the double-sided metal-clad laminate include electronic circuit base boards such as printed wiring boards and module boards in the field of electrics and electronics as well as the field of in-vehicle components. Meanwhile, other applications thereof include high heat resistant flexible printed boards, solar panel boards, high frequency wiring boards, and the like. The double-sided metal-clad laminate is particularly suitable for a flexible copper-clad laminate board that uses the insulating film as its base board.

EXAMPLES

The embodiment of the present invention will be described further in detail below by using examples and comparative examples. It is to be noted, however, that the present invention will not be limited only to these examples.
Materials used for the examples and the comparative examples are described below.

(1) Insulating films

Insulating films 1: films made of LCP resin manufactured by Ueno Fine Chemicals Industry, Ltd. (Product Number A-5000, Melting point 280°C, Crystallization temperature 230°C) and formed into thicknesses of 12 $\mu$m, 100 $\mu$m, 480 $\mu$m, and 600 $\mu$m by using a single shaft extruder and a T-die
Insulating film 2: a film made of LCP resin manufactured by Polyplastics Co., Ltd. (Product Number C950RX, Melting point 320°C, Crystallization temperature 275°C) and formed into a thickness of 100 $\mu$m by using a single shaft extruder and a T-die
Insulating film 3: a film made of LCP resin manufactured by Ueno Fine Chemicals Industry, Ltd. (Product Number P-9000, Melting point 340°C, Crystallization temperature 305°C) and formed into a thickness of 100 $\mu$m by using a single shaft extruder and a T-die

(2) Meatal foils

Copper foils: Manufactured by Mitsui Mining and Smelting Co., Ltd., Product Number TQ-M7-VSP, Thickness 12 $\mu$m

(Examples 1 to 8 and Comparative Examples 1 to 5)

By using the production apparatus 20 described in FIG. 1, two surfaces of each of the various commercially available insulating films described in Table 1 were brought into contact with two metal foils, and then the sets of the insulating film and the metal foils in this state were subjected to the heat and pressure applying step under various conditions described in Table 1 and were formed into laminates. Thereafter, the double-sided metal-clad laminates were produced by cooling these laminates.
The double-sided metal-clad laminates thus obtained were each dipped in an etching solution for base board production containing ferric chloride as the main component (Etching solution H-20L manufactured by Sunhayato Corp.) to dissolve and remove the copper foils and thus to take out the thermoplastic liquid crystal polymer layers. The obtained thermoplastic liquid crystal polymer layers were then cleaned with water and dried naturally.
Regarding the thermoplastic liquid crystal polymer layers, the degrees of planar orientation and the average coefficients of linear expansion were evaluated in accordance with the method described below. Moreover, peel strength of the copper foils was evaluated on each of the double-sided metal-clad laminates. Results of evaluation are shown in Table 1.

(Degree of planar orientation)

X-ray diffraction analyses were conducted by using an automated multipurpose X-ray diffractometer (SmartLab (3 kW) manufactured by Rigaku Corporation, configured for 2D-WAXS measurements). Measurement conditions are shown below.

X-ray source: Cu-sealed tube
Applied voltage: 40 kV
Current: 40 mA
X-ray output: 1.6 kW
Detector: Multi-dimensional pixel detector HyPix-3000

X-ray irradiation direction: perpendicular to film surface

Cumulative time: 10 minutes
Analysis 2θ angle range: 10° to 30°

Sampling width when plotting intensity in circumferential direction of two-dimensional diffraction image: 5°

An intensity in the case of measurement without setting each thermoplastic liquid crystal polymer layer on this device was subtracted as a blank from an intensity in the case of measurement of the thermoplastic liquid crystal polymer, and an obtained value was defined as the intensity of the thermoplastic liquid crystal polymer layer.

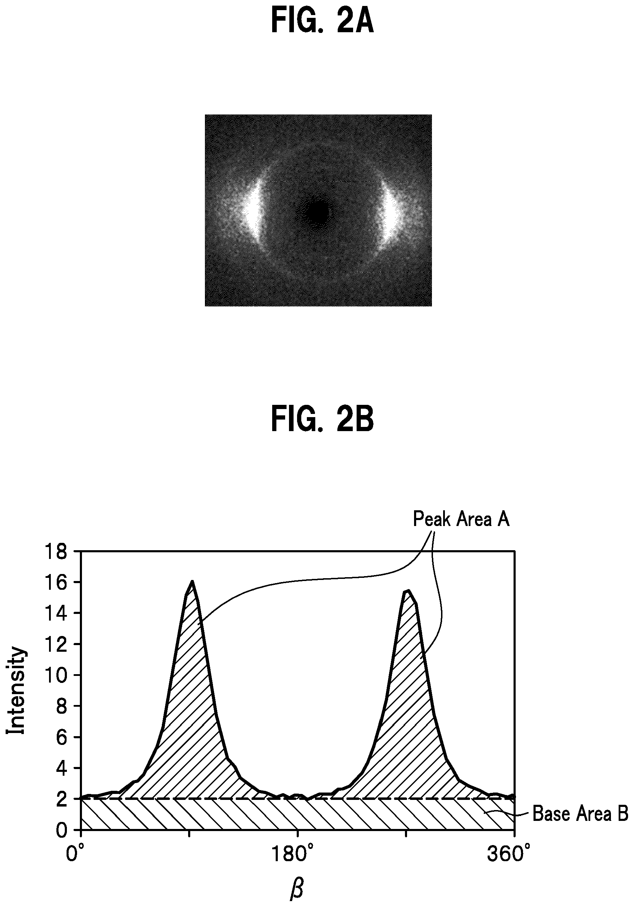

Regarding a two-dimensional diffraction image (FIG. 2A) thus obtained, an intensity curve was derived as shown in FIG. 2B by plotting the intensity with respect to a rotational angle β in the circumferential direction thereof. In FIG. 2B, a value of integral of a base portion (a base area) of the measured intensity corresponding to 360° of the circumference was defined as B while a value of integral of a portion obtained by subtracting the base portion from the measured peak portions (a peak area) was defined as A. In this case, the degree of planar orientation was calculated by the following formula:

$$\text{Degree of planar orientation (\%)} = \{A/(A + B)\} \times 100.$$

Degrees of planar orientation below 30% were determined to be acceptable.

(Average coefficients of linear expansion)

The average coefficients of linear expansion (ppm/K) in the MD direction and the TD direction in a temperature range from 23°C to 200°C were obtained in accordance with the TMA method in compliance with JIS K7197. An expansion is expressed by a positive (plus) value while a contraction is expressed by a negative (minus) value.

(Peel strength of copper foils)

A peeling force (N/mm) in the case of peeling each copper foil on the corresponding double-sided metal-clad laminate for 180° at a width of 10 mm and a rate of 50 mm/min was measured in compliance with JIS C6481.

Peel strengths of the copper foil of 0.5 N/mm or more were determined to be fine.

[Table 1]

| | | | Example 1 | Example 2 | Example 3 | Example 4 | Example 5 | Example 6 | Example 7 | Example 8 | Comparative Example 1 | Comparative Example 2 | Comparative Example 3 | Comparative Example 4 | Comparative Example 5 |
|---|---|---|---|---|---|---|---|---|---|---|---|---|---|---|---|
| Insulating film | Thickness | μm | 12 | 100 | 100 | 100 | 100 | 480 | 100 | 100 | 100 | 100 | 100 | 600 | 100 |
| | Degree of planar orientation | % | 63.5 | 56.8 | 56.8 | 56.8 | 56.8 | 48.9 | 36.2 | 67.8 | 56.8 | 56.8 | 56.8 | 56.2 | 56.8 |
| | Average coefficient of linear expansion | MD ppm/K | -20.8 | -19.1 | -19.1 | -19.1 | -19.1 | -15.6 | -17.8 | -19.8 | -19.1 | -19.1 | -19.1 | -5.6 | -19.1 |
| | | TD ppm/K | 90.7 | 81.5 | 81.5 | 81.5 | 81.5 | 75.4 | 80.7 | 86.5 | 81.5 | 81.5 | 81.5 | 76.4 | 81.5 |
| | Melting point | °C | 280 | 280 | 280 | 280 | 280 | 280 | 320 | 340 | 280 | 280 | 280 | 280 | 280 |
| Heating and pressure application conditions | Heating temperature | °C | 320 | 320 | 320 | 305 | 350 | 320 | 355 | 370 | 280 | 360 | 320 | 320 | 320 |
| | Pressure | MPa | 2 | 0.5 | 2 | 10 | 2 | 2 | 2 | 2 | 2 | 2 | 2 | 2 | 0.1 |
| | Heating and pressure application time | sec. | 30 | 180 | 180 | 360 | 180 | 360 | 180 | 180 | 180 | 30 | 15 | 360 | 180 |
| Properties of thermoplastic liquid crystal polymer layer of copper foil laminate | Thickness | μm | 11 | 100 | 100 | 100 | 98 | 475 | 100 | 100 | 100 | 74 | 100 | 500 | 100 |
| | Degree of planar orientation | % | 4.2 | 12.5 | 5.1 | 3.2 | 3.9 | 4.8 | 7.8 | 13.4 | 50.8 | 6.2 | 17.8 | 23.8 | 23.3 |
| | Average coefficient of linear expansion | MD ppm/K | 6.7 | 28.9 | 17.8 | 19.8 | 17.6 | 24.3 | 21.8 | 23.7 | -4.5 | -0.9 | -3.8 | 1.2 | 38.5 |
| | | TD ppm/K | 32.1 | 30.7 | 22.1 | 21.6 | 23.5 | 29.8 | 26.3 | 22.9 | 67.3 | 37.8 | 57.9 | 45.7 | 44.1 |
| Properties of copper foil laminate | Copper foil peel strength | N/mm | 0.7 | 0.7 | 0.8 | 0.8 | 0.7 | 0.8 | 0.7 | 0.8 | 0.5 | 0.8 | 0.7 | 0.8 | 0.6 |

From the evaluation results in Table 1, each of Examples 1 to 8 has the degree of planar orientation of below 30% and the average coefficients of linear expansion in the MD direction and the TD direction of 0 to 40 ppm/K. These examples also show good performances in terms of the copper foil peel strength. In contrast, Comparative Example 1 has the poor degree of planar orientation and the poor average coefficients of linear expansion because the heating temperature in the heat and pressure applying step was low. Comparative Example 2 has the poor average coefficient of linear expansion in the MD direction because the heating temperature in the heat and pressure applying step was too high. Comparative Example 3 has the poor average coefficients of linear expansion because the heating and pressure application time in the heat and pressure applying step was short. Comparative Example 4 has the poor average coefficient of linear expansion in the TD direction because the thickness of the insulating film is too large. Comparative Example 5 has the poor average coefficient of linear expansion in the TD direction because the pressure in the heat and pressure applying step was low.

Reference Signs List

| 1, 2 | endless-belt roll |
| --- | --- |
| 3 | endless belt |
| 4 | pressure application block |
| 5 | heater block |
| 6 | cooler block |
| 7 | guide roll |
| 11, 12, 13 | roll |
| 14 | conveyor device |
| 20 | production apparatus |

**Claims**

1. A method of producing a double-sided metal-clad laminate for producing a double-sided metal-clad including an insulating film which contains a thermoplastic liquid crystal polymer and is interposed between two metal foils, the method comprising:

   a supplying step of supplying an insulating film and two metal foils continuously to between a pair of endless belts;
   a heat and pressure applying step of forming a laminate of the insulating film and the two metal foils by heating and applying a pressure to the insulating film and the two metal foils while the insulating film is interposed between the two metal foils in between the endless belts; and
   a cooling step of cooling the laminate, wherein
   the insulating film has a thickness of 10 to 500 $\mu$m, a degree of planar orientation of 30% or more, an average coefficient of linear expansion in an MD direction of -40 to 0 ppm/K and an average coefficient of linear expansion in a TD direction of 0 to 120 ppm/K;
   a heating temperature T (°C) in the heat and pressure applying step complies with an inequality: (Tm + 20) < T ≤ (Tm + 70), wherein Tm represents a melting point of the thermoplastic crystal polymer;
   a pressure in the heat and pressure applying step is 0.5 to 10 MPa; and
   a time of heating and pressure applying in the heat and pressure applying step is 30 to 360 seconds.

2. The method of producing a double-sided metal-clad laminate according to claim 1, wherein
   a thermoplastic liquid crystal polymer layer after removing the metal foils from the obtained double-sided metal-clad laminate has a degree of planar orientation of below 30%, an average coefficient of linear expansion in an MD direction of 0 to 40 ppm/K and an average coefficient of linear expansion in a TD direction of 0 to 40 ppm/K.

3. The method of producing a double-sided metal-clad laminate according to claim 1 or claim 2, wherein the metal foils are copper foils.

4. An insulating film for use in a method of producing a double-sided metal-clad laminate, wherein the method comprising:

a supplying step of supplying an insulating film and two metal foils continuously to between a pair of endless belts;
a heat and pressure applying step of forming a laminate of the insulating film and the two metal foils by heating and applying a pressure to the insulating film and the two metal foils while the insulating film is interposed between the two metal foils in between the endless belts; and
a cooling step of cooling the laminate,
the insulating film containing a thermoplastic liquid crystal polymer, and
the insulating film has a thickness of 10 to 500 $\mu$m, a degree of planar orientation of 30% or more, an average coefficient of linear expansion in an MD direction of -40 to 0 ppm/K and an average coefficient of linear expansion in a TD direction of 0 to 120 ppm/K.

5. A double-sided metal-clad wherein

the double-sided metal-clad includes an insulating film containing a thermoplastic liquid crystal polymer and being interposed between two metal foils, and is produced by the method of producing a double-sided metal-clad laminate according to claim 1, and
the thermoplastic liquid crystal polymer layer after removing the metal foils from the obtained double-sided metal-clad laminate has a degree of planar orientation of below 30%, an average coefficient of linear expansion in an MD direction of 0 to 40 ppm/K and an average coefficient of linear expansion in a TD direction of 0 to 40 ppm/K.

6. A double-sided metal-clad according to claim 5, wherein the metal foils are copper foils.

7. An electronic circuit base board comprising the double-sided metal-clad according to claim 5 or claim 6.

# FIG. 1

EP 3 915 779 A1

# FIG. 2A

# FIG. 2B

**INTERNATIONAL SEARCH REPORT**

| International application No. |
| --- |
| PCT/JP2020/002058 |

A. CLASSIFICATION OF SUBJECT MATTER
B32B 15/08(2006.01)i; B29C 43/48(2006.01)n; H05K 3/00(2006.01)i
FI: B32B15/08 J; H05K3/00 R; B29C43/48
According to International Patent Classification (IPC) or to both national classification and IPC

B. FIELDS SEARCHED

Minimum documentation searched (classification system followed by classification symbols)
B32B15/08; B29C43/48; H05K3/00

Documentation searched other than minimum documentation to the extent that such documents are included in the fields searched
Published examined utility model applications of Japan 1922-1996
Published unexamined utility model applications of Japan 1971-2020
Registered utility model specifications of Japan 1996-2020
Published registered utility model applications of Japan 1994-2020

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| X | JP 2011-096471 A (SUMITOMO CHEMICAL CO., LTD.) 12.05.2011 (2011-05-12) claims, examples | 4 |
| Y A | WO 2015/050080 A1 (KURARAY CO., LTD.) 09.04.2015 (2015-04-09) claims, paragraphs [0066], [0071]-[0072], [0095]-[0098], examples | 5-7 1-4 |
| Y A | WO 2018/163999 A1 (MURATA MANUFACTURING CO., LTD.) 13.09.2018 (2018-09-13) claims, paragraphs [0027]-[0029] | 5-7 1-4 |
| Y A | JP 2017-047686 A (PRIMATEC INC.) 09.03.2017 (2017-03-09) claims, paragraphs [0001], [0076] | 5-7 1-4 |
| A | JP 2010-221694 A (PANASONIC ELECTRIC WORKS CO., LTD.) 07.10.2010 (2010-10-07) claims | 1-7 |
| A | WO 2016/170779 A1 (KURARAY CO., LTD.) 27.10.2016 (2016-10-27) claims, examples | 1-7 |

☒ Further documents are listed in the continuation of Box C.  ☒ See patent family annex.

| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 30 March 2020 (30.03.2020) | 07 April 2020 (07.04.2020) |

| Name and mailing address of the ISA/ Japan Patent Office 3-4-3, Kasumigaseki, Chiyoda-ku, Tokyo 100-8915, Japan | Authorized officer |
| | Telephone No. |

Form PCT/ISA/210 (second sheet) (January 2015)

**INTERNATIONAL SEARCH REPORT**

International application No.

PCT/JP2020/002058

C (Continuation). DOCUMENTS CONSIDERED TO BE RELEVANT

| Category* | Citation of document, with indication, where appropriate, of the relevant passages | Relevant to claim No. |
|---|---|---|
| A | JP 2001-270032 A (KURARAY CO., LTD.) 02.10.2001 (2001-10-02) examples | 1-7 |
| A | WO 2018/181223 A1 (DENKA COMPANY LIMITED) 04.10.2018 (2018-10-04) claims, examples | 1-7 |

Form PCT/ISA/210 (continuation of second sheet) (January 2015)

**INTERNATIONAL SEARCH REPORT**
Information on patent family members

| International application no. |
| --- |
| PCT/JP2020/002058 |

| Patent Documents referred in the Report | Publication Date | Patent Family | Publication Date |
| --- | --- | --- | --- |
| JP 2011-096471 A | 12 May 2011 | (Family: none) | |
| WO 2015/050080 A1 | 09 Apr. 2015 | US 2016/0212845 A1 claims, paragraphs [0116], [0121]-[0122], [0155]-[0160], examples CN 105637019 A KR 10-2016-0065942 A | |
| WO 2018/163999 A1 | 13 Sep. 2018 | US 2019/0357355 A1 claims, paragraphs [0035]-[0036] CN 110290921 A | |
| JP 2017-047686 A | 09 Mar. 2017 | (Family: none) | |
| JP 2010-221694 A | 07 Oct. 2010 | (Family: none) | |
| WO 2016/170779 A1 | 27 Oct. 2016 | US 2018/0134025 A1 claims, examples EP 3287260 A1 CN 107530979 A KR 10-2017-0138470 A | |
| JP 2001-270032 A | 02 Oct. 2001 | (Family: none) | |
| WO 2018/181223 A1 | 04 Oct. 2018 | CN 110475655 A claims, examples KR 10-2019-0127762 A | |

Form PCT/ISA/210 (patent family annex) (January 2015)

**EP 3 915 779 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 5411656 B
- JP 2016129949 A